# EUROPEAN PATENT APPLICATION

(11) **EP 4 831 655 A1**
(43) Date of publication of application: **28.10.2026**
(21) Application number: 25305597.4
(22) Date of filing: 25.04.2025
(51) Int. Cl.: G01R 31/00, G01R 31/34

(54) **METHOD AND CONTROL UNIT FOR DETECTING A MECHANICAL DEFECT OF A DRIVE UNIT**

(71) Applicant: ALSTOM Holdings, 93400 Saint-Ouen-sur-Seine (FR)
(72) Inventor: VOGELSBERGER, Markus, 6152 Trins (AT); ZANUTTI, Cedric, B5070 Sart-Eustache (BE); WOLBANK, Thomas, 1050 Wien (AT)
(74) Representative: SONN Patentanwälte GmbH & Co KG

(57) **Abstract**

Method for detecting a mechanical defect of a drive unit (5), wherein the drive unit (5) comprises a suspension (8), a converter (6) and an electric machine (7), the electric machine (7) having a stator (19), a rotor (20) and at least two phase windings (U,V,W), wherein the method comprises the following steps:
providing electrical signals (40) to one or more of the at least two phase (U,V,W) windings;
measuring an electrical signal waveform in one or more of the at least two phase windings (U,V,W);
determining a saliency signal (ϑ_{Saliency}) from the measured electrical signal waveform;
comparing the saliency signal (ϑ_{Saliency}) or a further processed signal thereof with at least one threshold value (T);
determining that a mechanical defect of the drive unit (5) has occurred when the saliency signal (ϑ_{Saliency}) or the further processed signal exceeds the at least one threshold value (T).

## Description

The invention relates to a method for detecting a mechanical defect of a drive unit, in particular a drive unit of a rail vehicle, wherein the drive unit comprises a suspension, a converter and an electric machine, the electric machine having a stator, a rotor and at least two phase windings, wherein the method comprises the following steps:
providing electrical signals to one or more of the at least two phase windings by the converter;
measuring an electrical signal waveform, in particular a current signal waveform, in one or more of the at least two phase windings;
determining a saliency signal which preferably comprises an intermodulation signal component, a slot signal component and/or a saturation signal component from the measured electrical signal waveform.

Further, the invention relates to a control unit for detecting a mechanical defect of a drive unit, in particular a drive unit of a rail vehicle, the control unit being configured to measure an electrical signal waveform, in particular current signal waveform, in one or more phase windings of an electric machine, wherein the control unit comprises a processing unit which is configured to determine a saliency signal which preferably comprises an intermodulation signal component, a slot signal component and/or a saturation signal component from the measured electrical signal waveform.

Modern rail vehicles, such as trains, locomotives and trams, are typically powered by one or more electric machines mounted to bogie frames via suspensions. These suspensions are subjected to considerable mechanical stress and thus can degrade over time due to fatigue. To avoid the drop down of the electric machine in the event of a suspension failure, retention elements are typically integrated into drive units of rail vehicles, enhancing safety of the rail vehicle. These retention elements are usually guided through safety catches on or at the electric machines and serve as a last safety measure, ensuring that the machine remains secured to the rail vehicle. In other words, they prevent the electric machine from detaching and falling onto the track when the suspension is defect. Even when a suspension is damaged, the retention element allows for a continued operation of the rail vehicle - at least until it reaches a maintenance facility or the next train station.

To ensure safe operation, it is essential to detect broken or defective suspensions or other mechanical faults in the drive system and take appropriate measures. In current practice, mechanical inspections are typically carried out at regular intervals in the maintenance facilities of the rail operator by specialized experts.

In other approaches known in the prior art, rotational sensors applied to the drive units of rail vehicles are used for this purpose. For example, DE 10 2011 089 101 A1 describes a method for detecting faults in a vehicle's drivetrain using a rotary encoder. Similar concepts are outlined in WO 2015/128233 A1 and DE 10 2014 203 720 A1. However, these systems rely on high-resolution rotary encoders to detect suspension defects, which adds cost and complexity. Additionally, the encoders themselves are susceptible to failure.

In the light of the above said, it is an objective of the present invention to eliminate or at least alleviate the disadvantages of the prior art. Preferably it is an objective of the present invention to provide a method and a control unit as described above that can quickly and reliably detect mechanical defects in the drive unit of a rail vehicle without the need of additional sensors, such as encoders, and specialized service staff.

The above objective is solved by a method for detecting a mechanical defect of a drive unit according to claim 1 and a control unit for detecting a mechanical defect of a drive unit according to claim 14.

According to the invention, a method for detecting a defect of a suspension of a drive unit as described above further comprises:
comparing the saliency signal, in particular the intermodulation signal component, the slot signal component and/or the saturation signal component, or a further processed signal thereof with at least one threshold value;
determining that a mechanical defect of the drive unit has occurred when the saliency signal, in particular the intermodulation signal component, the slot signal component and/or the saturation signal component, or the further processed signal exceeds the at least one threshold value.

Advantageously, by using the saliency signal, preferably the intermodulation signal component and/or the slot signal component, or a further processed signal thereof, the use of additional sensors, such as rotary encoders or strain gauges, can be avoided. Another advantage is that mechanical defects of the drive unit can be detected during operation of the rail vehicle without the need of inspection by specialized personnel in a maintenance facility. Thus, the required inspection time, in which the rail vehicle cannot be used as intended, can be reduced. The rail vehicle according to the invention may be, for instance, a train, locomotive or a tram. Although the invention is strongly related to rail vehicles, it shall be noted that the invention is not limited to rail vehicles only, but also to other vehicles propelled by electric machines and potentially subject to mechanical defects in a drive unit. For the sake of simplicity, the invention will be described in the context of rail vehicles. The inventive method may be carried out during operation of the rail vehicle, in particular in stand stills. For example, rail vehicles stand still in rail vehicle stations. The inventive method can be carried out on a regular or irregular basis during operation of the rail vehicle. In this context, operation of the rail vehicle refers to the intended use of the rail vehicle. Thus, if the rail vehicle is intended for the transport of passengers and goods, the inventive method may also be carried out with passengers or goods being inside the rail vehicle or inside a wagon connected to the rail vehicle. The mechanical defect that can be detected by the method may be, for example, a defect in the suspension, in a drive shaft, a bogie or in a transmission. A prominent example for a mechanical defect is the break of the suspension such that the electric machine is caught by a retention element which avoids a contact of the electric machine with the track. The retention element may be, for example, a retention bar attached to a bogie of the rail vehicle. Another example of a mechanical defect is a defect of a shaft. The inventors have found out that mechanical defects in the drive unit introduce signal components into the saliency signal of the electric machine when the electric machine is operated, in particular into the intermodulation signal component, into the slot signal component and/or into the saturation signal component, which are not present in the absence of such mechanical defects. Thus, when such components are present in the saliency signal, this is an indication that the drive unit is subject to a mechanical defect. As a consequence, the further operation of the rail vehicle may be stopped or limited, for example in speed or distance. Primarily, the mechanical defects may introduce additional signal components at certain frequency ranges into the intermodulation signal component, the slot signal component and/or saturation signal component. The respective frequency range is dependent on the mechanical arrangement of the drive train, its time constants as well as the applied drive unit excitation signal, which will be described below. The signal components due to the mechanical defects may have a frequency higher or lower than the fundamental frequency of the intermodulation signal component and/or saturation signal component. Thus, if such signal components are being identified, mechanical defects can be considered detected. This can be done by comparing the saliency signal, preferably the intermodulation signal component, the slot signal component and/or the saturation signal component - or parts thereof - with at least one threshold value. In the present invention, the intermodulation signal component, the slot signal component and/or the saturation signal component, may be used to detect mechanical defects as mechanical defects may influence all those signal components. However, preferably the intermodulation signal component or a further processed signal thereof is used to detect mechanical defects as this signal has relatively high amplitudes also at low rotational speeds of the electric machine. The threshold value may be, for example, a constant value. However, the threshold value may also be a time and/or frequency dependent value. Instead of the saliency signal, also a further processed signal may be used. For example, the saliency signal, in particular the intermodulation signal, the saturation signal component or the slot signal component, may be filtered, cut off and/or squared. However, it is essential that the signal used to determine a mechanical defect originates from the saliency signal. The saliency signal, particularly the intermodulation signal component and/or slot signal component, may be analysed in the frequency or time domain. The mechanical defects may alter the amplitude and/or phase of the intermodulation signal component, the slot signal component and/or saturation signal component. However, the identification of signal components due to mechanical defects is preferably performed in the frequency domain or time-frequency-domain as the signal components due to mechanical defects typically appear in distinct frequency ranges. In the time-frequency domain, signal components of a certain frequency may be accorded to specific events in time, such as torque steps. By measuring the electrical signal waveform in one or more of the windings of the electric machine, the saliency signal containing the saturation signal component, the intermodulation signal component and the slot signal component can be obtained. The intermodulation signal component and the slot signal component can be obtained from asynchronous machines and electric machines with at least partially asynchronous-machine-like character. Reluctance machines may also have asynchronous character. Preferably, the electrical signal waveforms of at least two windings, in particular three windings, are mathematically combined with each other and the saliency signal is obtained therefrom. The intermodulation signal component is mainly caused by effects of the slotting of the rotor and/or the stator of the electric machine as well as by effects of the magnetic saturation of magnetic flux paths within the electric machine. In most operating states, the intermodulation signal component has a different fundamental frequency than the slot signal component and the saturation signal component. The signal components generated by the slotting of the rotor and of the stator of the electric machine in the current waveform are referred to as slot signal components. The fundamental frequency of the slot signal components usually corresponds essentially to n times the rotation frequency of the rotor, where n corresponds to the number of slots of the rotor in this context. The signal components induced in the current waveform caused by temporal and local variation of the magnetic saturation of magnetic flux paths within the rotary current machine are referred to as saturation signal components. The fundamental frequency of the saturation signal component normally corresponds essentially to twice the fundamental- or operating-period of the machine. By physically combining the two effects mentioned above, their electrical signal components are also combined, thereby generating the intermodulation signal component, the frequency of which is different from the frequencies of the saturation signal component and the frequencies of the slot signal component in most operating states. The effect of the described intermodulation occurs in particular in asynchronous machines and electric machines with at least partially asynchronous-machine-like character, which is why the method according to the invention is particularly suitable for controlling asynchronous machines or machines with asynchronous-machine-like character. The relationship between the frequencies of the intermodulation signal component, the slot signal component and the saturation signal component is ${ω}_{inter} = \pm {ω}_{sat} - {ω}_{slot} ,$ (1) where ωᵢₙₜₑᵣ is the frequency of the intermodulation signal component, ωₛₐₜ is the frequency of the saturation signal component, and ωₛₗₒₜ is the frequency of the slot signal component. The sign of ωₛₐₜ in equation (1) depends on the construction and design of the electric machine. The saturation signal component can be determined from the currents in the phase windings of the electric machine. A detailed description of the saliency signal containing the saturation signal component, the intermodulation signal component and the slot signal component as well as the determination thereof can be found in WOLBANK T M ET AL: "Comparison of inherent saliency tracking methods for zero speed sensorless control of standard induction machines", ELECTRIC MACHINES AND DRIVES CONFERENCE, 2009. IEMDC '09. IEEE INTERNATIONAL, IEEE, PISCATAWAY, NJ, USA, May 3rd, 2009 (2009-05-03), pages 1258-1263. In the prior art, the intermodulation signal is typically considered as disturbance that has to be suppressed. However, in the present disclosure, the intermodulation signal may be used to detect mechanical defects. The suspension may be configured to fix the electric machine, which may also be referred to as electric motor, to a bogie of the rail vehicle. The bogie may comprise a frame that has at least one beam. The electric machine may be attached to the frame via one or more suspension elements. The one or more suspension elements may be mounted to the frame. Also, the drive unit may also comprise one or more wheels or one or more pairs of wheels that may be mounted to the frame. The electric machine has a stator and a rotor. The rotor is rotable relative to the stator. By means of the at least two phase windings, a rotating electromagnetic field can be generated in a gap between the stator and the rotor in order to induce currents into rotor and hence to rotate the rotor. To this end, the converter may generate the electrical signals that may be fed into the at least two phase windings. The converter may use PWM-signals as electrical signals fed into the electric machine. Preferably, a field-oriented control method may be applied to control the electric machine. Of course, also comparable alternative control approaches, such as direct torque control methods, flux control methods or indirect field orientation control methods may be applied. The control method may be carried out by a control unit that also may be configured to carry out the inventive method. The inventive method may be conducted when the rail vehicle stands still or when the rail vehicle moves. In order to determine the occurrence of a mechanical defect, the intermodulation signal component, the slot signal component, the saturation signal component or a further processed signal thereof may be used. Further processing of said signals may comprise, for example, filtering, squaring or combining one or more of said signals.

In order to facilitate detection of signal components related to mechanical defects, the saliency signal, in particular the intermodulation signal component, the slot signal component and/or the saturation signal component, or the further processed signal may be transformed into a frequency domain or a time-frequency domain, wherein within at least one frequency range at least one part of the transformed saliency signal or of the further processed signal is compared with the at least one threshold value. The inventors have found out that mechanical defects of the drive unit, in particular the suspension, introduce signal components of certain frequencies, which depend on the specific design of the drive unit and the type of mechanical defect, into the saliency signal. In most cases, the introduced signal components alter the intermodulation signal component, the slot signal component and/or the saturation signal component. In one example, a broken suspension may introduce signal components, that, depending on the mechanical drive configuration, may be in the range between 1 Hz and 10 Hz, which would not be present if the suspension was healthy. As the frequency of the introduced signal components may be estimated based on simulations, calculations and/or empirical tests, it is sufficient to analyse only one or more frequency ranges in which signal components may appear in case of mechanical defects. For example, the at least one frequency range may extend between 1 Hz and 20 Hz. In order to clearly identify such signal components, fundamental frequencies that originate from the normal operation of the electric machine may be supressed by filtering. In the frequency domain, signals are represented as function of the frequency. In the time-frequency domain, signals are represented as function of the frequency and of time. The time-frequency domain combines both dependencies, i.e., time and frequency, and entails the advantage that, if a drive unit excitation signal is used, signal components of the response can be timely associated with the drive unit excitation signal, thereby additionally avoiding mistakes in the interpretation of the result.

Preferably, the transformation into the frequency domain is carried out by a frequency transform, in particular Fourier Transform, and the transformation into the time-frequency domain is carried out by a time-frequency-transform, in particular a Wavelet Transform or a Short-Time Fourier Transform. Said transforms may be time-discrete transforms, such as Fast Fourier Transform (FFT). For time-frequency-transform, a Wavelet Transform may be used. Alternatively, Short-Time Fourier Transformmay be used.

As mentioned above, mechanical defects can appear at different parts or sections in the drive unit, such as the suspension, the shaft or a transmission. The inventors have found out that mechanical defects at different sections in the drive unit can lead to the introduction of signal components with different frequencies into the saliency signal. This is based on the fact that the sections or parts of the drive unit, such as gears, shafts, bogies and suspensions, each can have different excitable frequencies which may be altered differently by mechanical defects. Based on this finding, it can be determined from the frequency of the introduced signal component in which section of the drive unit a mechanical defect has appeared. In this way, a localisation of the mechanical defect can be performed. Thus, in a preferred embodiment, frequency ranges of the saliency signal, in particular of the intermodulation signal component, or of the further processed signal are accorded to sections of the drive unit and that threshold values are accorded to the frequency ranges, wherein the mechanical defect of a section of the drive unit is determined when a part of the transformed saliency signal exceeds the accorded threshold value of the respective frequency range or a part of the further processed signal exceeds the accorded threshold value of the respective frequency range. The frequency ranges each can have the same or different interval length. The sections may correspond to components or parts of the drive unit, such as the suspension, the shaft, the transmission and/or the axle. The frequency ranges can be distant to each other or share the same interval boundaries. In one example of the invention, a signal component arises in a frequency range that is accorded to the transmission. When the signal component exceeds the threshold, it can be concluded that the transmission is subject to a mechanical defect. The identification of the frequency ranges may be based on calculations, simulations or empirical tests.

In one embodiment of the invention, the drive unit at least comprises the suspension, the electric machine and a transmission and preferably a bogie. The suspension may comprise at least one suspension element with which the electric machine is attached to the bogie, in particular a beam of a bogie. The transmission may comprise multiple gears for transmission of torque to the wheels. The bogie may comprise a frame that has one or more beams to which the electric machine and the transmission may be mounted.

Preferably, the at least one threshold value is related to an amplitude value. The relation may be proportional or exponentially. For example, the threshold value may be a quadratic amplitude value. Squaring the amplitude value and also the saliency signal can facilitate the detection of small abnormalities in the signal. As described above, for detecting the mechanical defect, a further processed signal may be used. The further processed signal may be, for example, a quadratic signal of the saliency signal, in particular the intermodulation signal. The quadratic signal of the intermodulation signal may be compared with the squared amplitude value. If the squared signal exceeds the threshold value, a mechanical defect may be determined.

The electric machine may be a synchronous machine or an electric machine having asynchronous character, such as an induction machine or a reluctance machine. The induction machine may also be referred to as asynchronous machine. In particular with regard to induction machines, the use of the intermodulation signal is advantageous as it is already visible at a low rotor speed. However, also other signal components of the saliency signal, such as the slot signal component, are visible at a low rotor speed.

Preferably, the drive unit is disposed in a rail vehicle, in particular a train, locomotive or a tram, and the method is carried out when the rail vehicle initially stands still. In other words, the method is carried out when the rail vehicle does not move initially. In this way, unwanted influences that may arise during the train is in motion, can be advantageously supressed. By conducting the inventive method, the rail vehicle may be moved upon generating a torque which may lead to a movement, in particular an acceleration, of the rail vehicle. In other words, the rail vehicle may be moved from a stand-still by the torque generated during the inventive method.

At least one brake of the rail vehicle may optionally be activated to counteract acceleration of the rail vehicle. In this way, movement of the rail vehicle can be avoided.

In order to determine mechanical defects, a drive unit excitation signal is generated and applied to the electric machine and, upon generation of the drive unit excitation signal, the saliency signal, in particular the intermodulation signal component, or the further processed signal is determined. The drive unit excitation signal causes the electric machine to excite mechanical oscillations which are then visible in the saliency signal. The drive unit excitation signal may be generated with the converter and fed into the electric machine. The drive unit excitation signal may lead to the generation of torque by the electric machine, in particular one or more torque steps. Mechanical defects may cause a clearance or looseness in the drive unit of the rail vehicle which leads to movements, in particular oscillations, of the rotor relative to the stator. These movements can introduce signal components into the saliency signal. The drive unit excitation signal may be generated when the rail vehicle stands still or during movement of the vehicle. In a preferred embodiment, the drive unit excitation signal leads to the generation of a torque step by the electric machine. Depending on the mechanical arrangement of the drive unit, the drive unit excitation signal may be applied to the electric machine and may have a length of at least 0.5 seconds, at least 1 second, at least 2 seconds or at least 3 seconds. When the drive unit excitation signal leads to the generation of one or more torque steps, each torque step may have a length of at least 0.5 seconds, at least 1 second, at least 2 seconds or at least 3 seconds.

In a preferred embodiment, the drive unit excitation signal leads to the generation of torque by the electric machine, which torque is preferably applied in the form of one or more torque steps. The generated torque can lead to the acceleration of the rail vehicle. However, this acceleration can be prevented by activating brakes of the rail vehicle. Torque may be applied either while the rail vehicle is stationary or in motion. For the purpose of detecting mechanical defects, it is irrelevant whether the torque step is introduced during stand-still or movement. In both scenarios, atypical rotor movements - particularly oscillations - can be detected and triggered. Such atypical behaviour would not occur if the drive unit were free of mechanical defects, as these movements would be effectively suppressed. Depending on the arrangement of the drive unit, the torque step may have an absolute value of at least 5 %, at least 10 %, at least 15 %, or at least 20 % of a maximum torque value or of a torque value used as reference value. The step may have a length of at least 0.5 seconds, at least 1 second, at least 2 seconds or at least 3 seconds. If multiple torque steps are applied, these may have a different polarity, length and/or height. In this way, the drive unit can be excited more extensively such that mechanical defects can be detected more reliably.

The electric machine may be suspended by the suspension, preferably wherein a retention element is provided. The retention element may be a bar or a rod, for example, that can be guided through a recess, in particular a hole, in or at the housing of the electric machine. Preferably, the recess is provided in a holding element protruding from the housing of the electric machine. In one embodiment, multiple holding elements are provided through which the retention element is guided. In cases when the suspension is defect, the retention element in combination with the holding element prevents the electric machine from getting into contact with the tracks underneath the rail vehicle.

In particular when starting electric machines without a sensor placed at the rotor shaft, initial values for relevant signals are typically unknown. These values must then be gained during operation of the electric machine. Thus, in one embodiment of the invention, initial values for amplitudes and/or phase angles, in particular for zero-phase angles, of the intermodulation signal component and/or of a slot signal component are estimated, preferably iteratively. For example, the zero-phase angle of the intermodulation signal component and the slot signal component may be estimated, preferably iteratively. To this end, preferably converging algorithms may be used. The estimation may take place in no-load conditions and during a stand-still of the rail vehicle.

The objective of the present invention is also solved by a control unit as described above, wherein the processing unit is further configured to compare the saliency signal, in particular the intermodulation signal component, the slot signal component and/or the saturation signal component, or a further processed signal thereof with at least one threshold value, and to determine that a mechanical defect of the drive unit has occurred when the saliency signal, in particular the intermodulation signal component, the slot signal component and/or the saturation signal component, or the further processed signal exceeds the at least one threshold value.

The control unit is preferably configured to carry out the above-described method for detecting a mechanical defect of a drive unit. All features, advantages and effects described in connection with the method also apply to the control unit, and vice versa. The control unit may be formed by one or more processing units, such as microprocessors. The control unit may also comprise or be connected to one or more electrical sensors, such as voltage or current sensors. Preferably, the control unit comprises or is connected to current sensors to measure the currents in at least two phase windings of the electric machine. In an alternative embodiment, the currents in the at least two phase windings may be determined from a measured current in a DC link of the converter and the state of the switches in the converter at the moment. To this end, a current sensor may be placed in the DC link. In one embodiment of the invention, the control unit may be an independent unit that can be integrated into an existing system. However, it is not excluded that the control unit may also perform other tasks than the inventive method, such as controlling the converter and the electric machine. Thus, the controlling may also be configured to carry out field-oriented control, direct flux/torque control methods or indirect control methods of the electric machine. In this way, speed, position and/or torque of the electric machine may be controlled by the control unit. Therefore, any unit with a processing unit that, besides other tasks, is configured as described above, in particular to conduct the inventive method, is to be understood as control unit in the sense of this disclosure.

The invention is also related to a vehicle, in particular a rail vehicle, comprising a drive unit having:
a converter;
an electric machine;
a suspension; and
a control unit as described above.

The drive unit may also comprise a shaft, a transmission, an axle and at least one wheel or one pair of wheels. The transmission may comprise at least two gears, preferably arranged within a gear box. The electric machine is preferably an induction machine. The suspension may suspend the electric motor. In one embodiment, the suspension may also suspend the transmission.

In a more general aspect, the invention relates to a method and a control unit which allow to detect mechanical defects in a drive unit based on an electric machine response signal. The saliency signal is contained in the electric machine response signal which, which, besides the saliency signal, also comprises other signals. A mechanical defect in the drive unit may not only influence the saliency signal, but also other signals that may not considered as saliencies, such as signals related to the magnetic flux and its linkage within the electric machine. As described below in connection with the saliency signal, the electric machine response signal may be measured with electrical sensors, such as current sensors. The electric machine response signal, which comprises the saliency signal but also contains other signals, such as a magnetic flux signal, may be determined as described below in connection with the saliency signal, namely with excitation signals fed into the electric machine and measurement. By measuring the electrical signal waveform, in particular the electrical current waveform, in at least two windings, the electric machine response signal may be determined. The response signal may contain the saliency signal and one or more flux signals. The saliency signal may be extracted from the electric machine response signal, for example by filtering. However, also other signals, such as flux signals, may be extracted from the electric machine response signal, e.g., by filtering or tracking methods using mathematical models. In one embodiment, a mathematical model for determining the magnetic flux, in particular the fundamental wave of the magnetic flux or the flux linkage within the electric machine, may be used to track and hence extract the magnetic flux signal from the response signal. Such mathematical models are known in the prior art. By comparing the magnetic flux signal extracted from the electric machine response signal with a threshold value, a mechanical defect can be determined as well, similar to the method described above that focuses on the saliency signal. The procedure is the same as described for the saliency signal. Thus, if the magnetic flux signal exceeds the threshold, a mechanical defect in the drive unit may be determined. Preferably, the magnetic flux signal, is transformed into the frequency domain or the time-frequency domain and then compared with the threshold value. The electric machine may be a synchronous machine or a machine having asynchronous character, such as an induction machine. All features, advantages and effects described above all apply analogously to the more general aspect of the invention using the electric machine response signal.

With regard to the electric machine response signal, the invention may be described as follows:
Method for detecting a mechanical defect of a drive unit, in particular a drive unit of a rail vehicle, wherein the drive unit comprises a suspension, a converter and an electric machine, the electric machine having a stator, a rotor and at least two phase windings, wherein the method comprises the following steps:
providing electrical signals to one or more of the at least two phase windings by the converter;
measuring an electrical signal waveform, in particular a current signal waveform, in one or more of the at least two phase windings;
determining an electric machine response signal which preferably comprises a saliency signal and/or a magnetic flux signal;
comparing the electric machine response signal or a further processed signal thereof with at least one threshold value;
determining that a mechanical defect of the drive unit has occurred when the electric machine response signal or the further processed signal exceeds the at least one threshold value.

In the following, the invention is described with reference to figures, to which it is not limited. The figures show:
Fig. 1 a schematic rail vehicle;
Fig. 2A a schematic drive unit according to a first embodiment; Fig. 2B a schematic drive unit according to a second embodiment;
Fig. 3 a simplified representation of a drive unit in a perspective view;
Fig. 4A-C show schematic side views of gears and retention elements guided through holding elements;
Fig. 5 a block diagram of a converter and an electric machine;
Fig. 6 a schematic circuit diagram of an electric machine connected to a converter;
Fig. 7 a cross-sectional view of an electric machine;
Fig. 8A-C illustrate saliency excitation signals and resulting current waveforms;
Fig. 9A shows a schematic view of an exemplary saliency excitation signal;
Fig. 9B shows schematic current waveforms in response to the excitation signal according to Fig. 9A (at different rotor positions);
Fig. 10A a saliency signal in the time domain;
Fig. 10B a saliency signal in the frequency domain;
Fig. 11 a saliency signal and an intermodulation signal component in the time domain and in the frequency domain;
Fig. 12 a torque, a mechanical angle, a saliency signal and an intermodulation signal component upon application of a torque step when there is no mechanical defect;
Fig. 13 a wavelet diagram of the intermodulation signal component of Fig. 12;
Fig. 14 a torque, a mechanical angle, a saliency signal and an intermodulation signal component upon application of a torque step when there is a mechanical defect;
Fig. 15 a wavelet diagram of the intermodulation signal component of Fig. 14;
Fig. 16 a diagram with vectors in a specific operating state of an electric machine; and
Fig. 17A-D diagrams of vectors during an algorithm for the estimation of phase angles.

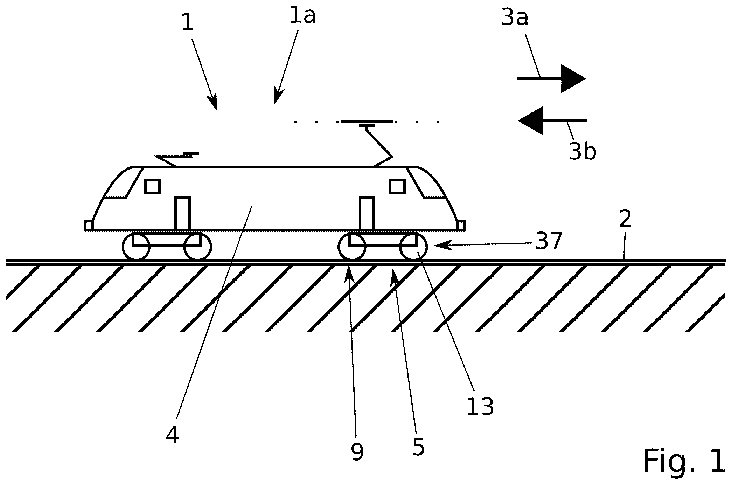

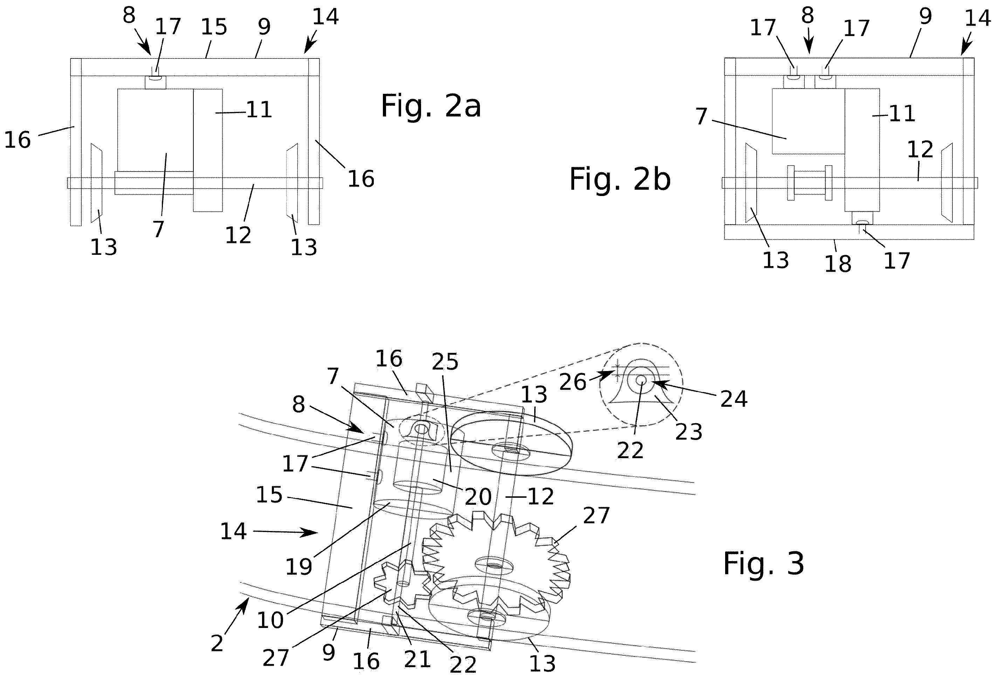

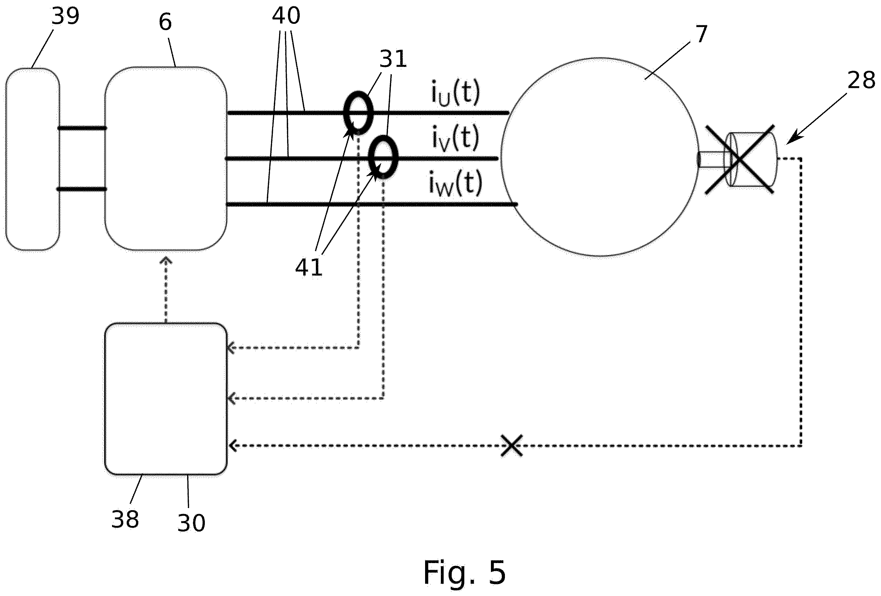

Fig. 1 schematically illustrates a rail vehicle 1, in particular a train 1a, on rails 2 moving into a first direction 3a. The rail vehicle 1 may also move into a second direction 3b opposite to the first direction 3a. The rail vehicle 1 is a traction rail vehicle 4 with at least one drive unit 5 that powers the rail vehicle 1 and transmits the driving force to the rails 2. As can be also seen in Fig. 2A and Fig. 2B in greater detail, the drive unit 5 comprises an electric machine 7, a suspension 8 for the electric machine 7, a bogie 9, a shaft 10, a transmission 11, an axle 12 and at least two wheels 13. Fig. 5 also illustrates a converter 6 of the drive unit 5. In the context of this disclosure, the drive unit 5 is to be understood as a unit that comprises electrical, mechanical and electromechanical parts that are intended and configured to propel the rail vehicle 1.

Fig. 2A and Fig. 2B schematically show different embodiments of exemplary drive units 5 in a top view.

Fig. 2A shows a frame 14 of a bogie 9 which comprises a middle beam 15 and two side beams 16. The electric machine 7 is attached via the suspension 8 to the frame 14. The suspension 8 comprises at least one suspension element 17 by means of which the electric machine 7 is mounted to the frame 14. The suspension 8 secures the electric machine 7 to the bogie 9. The electric machine 7 is coupled to the transmission 11, which transmits rotation generated by the electric machine 7 to the axle 12. The configuration shown in Fig. 2A may also be referred to as nose suspended drive.

Fig. 2B illustrates a frame 14 of a bogie 9 which comprises a middle beam 15, two side beams 16 and a head beam 18. The electric machine 7 is mounted to the middle beam 15 via two suspension elements 17 of the suspension 8. However, also only one or more than two suspension elements 17 may be used. Further, the transmission 11 is mounted to the head beam 18 via another suspension element 17. The electric machine 7 is coupled to the transmission 11, which transmits rotation to the axle 12. The configuration shown in Fig. 2B may also be referred to as fully suspended drive.

Fig. 3 shows a simplified representation of a drive unit according to the nose suspended drive type (see Fig. 2A). As already explained, the electric machine 7 is mounted via suspension elements 17 to the bogie 9. As can be seen in Fig. 3, the electric machine 7 comprises a stator 19, which is depicted as transparent for illustration purposes. The stator 19 encompasses a rotor 20 which is coupled to the transmission 11 via the shaft 10. In Fig. 3, the transmission 11 is represented by two gears 27. The transmission 11 is coupled to the axle 12. The transmission 11 comprises multiple gears 27.

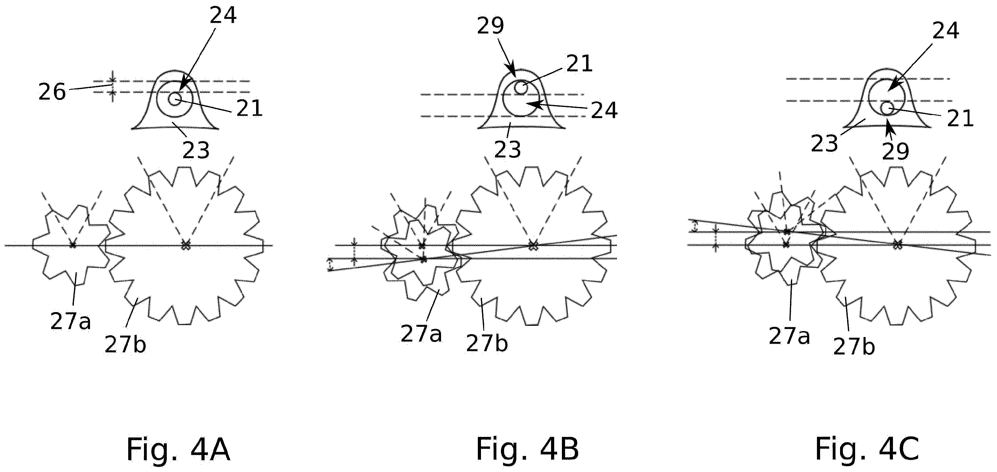

Due to fatigue, mechanical defects may occur in the drive unit 5. A prominent example is a defect in the suspension 8, which may occur from time to time. If the suspension 8 breaks, the electric machine 7 could come loose and drop onto the rails 2. This can lead to dangerous situations, in particular during operation of the rail vehicle **1.** In order to prevent the electric machine 7 from dropping onto the rails 2, a retention element 21 can be provided. The retention element 21 may be a bar 22 that is attached to the frame 14, in the embodiment shown to the side beams 16 on opposite sides. As schematically indicated in Fig. 3, the retention element 21 is guided through one or more holding elements 23 with recesses, in particular holes 24. The holding elements 23 may be attached to or form a part of the housing 25 of the electric machine 7, in particular the stator 19. In one embodiment, the holding elements 23 form protrusions of the housing 25 with a hole 24. When the suspension 8 is healthy, i.e. does not have a defect, there is a circumferential clearance 26 between the retention element 21 and the holes 24 (see also Fig. 4A). The clearance 26 avoids the direct contact of the retention element 21 with the holding element 23 and thus with the electric machine 7 when the suspension 8 is healthy. This avoids influence of the retention element 21 onto the stiffness of the suspension 8. The one or more holding elements 23 with the recesses may also be referred to as safety catch elements. In case of a broken suspension 8, the retention element 21 and the holding elements 23 cooperate together and prevent the electric machine 7 from dropping onto the rails 2. In this case, there is no circumferential clearance 26 between the retention element 21 and the holes 24 anymore. However, severe accidents are avoided in this way. Some rail vehicles 1 also allow limited operation when the electric machine 7 is caught by the retention element 21.

Fig. 4A-C show schematic side views of gears 27a, 27b of the transmission 11 and retention elements 21 guided through holding elements. Fig. 4A shows the arrangement of a retention element 21 within a holding element 23 when the suspension 8 is healthy. It can be seen that there is a circumferential clearance 26 essentially evenly around the retention element 21. In other words, there is no direct contact between the retention element 21 and the holding element 23.

Fig. 4B and Fig. 4C show the arrangement of a retention element 21 within a holding element 23 when the suspension 8 is broken. In this case, the retention element 21 comes into contact 29 with the holding element 23. Thus, there is no circumferential clearance 26 around the retention element 21. Depending on the rotational direction, the contact 29 may be at different locations. The location of the contact 29 depends on, among other factors, the applied torque, which may lift the electric machine 7 upwards. When torque is applied, the contact may not be static, but moving around within the hole 24.

Fig. 5 shows an electric block diagram of the converter 6, the electric machine 7 and a control unit 30. The converter 6 is electrically connected with a power supply 39. The control unit 30 has a processing unit 38 and is configured to control the converter 6 and the electric machine 7. In particular, sensorless control methods may be applied, which are already known in the prior art. The term "sensorless" refers to the use of mechanical sensors, such as encoders 28. This is depicted in Fig. 5 by the crossing of the encoder 28. Of course, sensors 31 for measuring at least two currents of the currents iᵤ(t), iᵥ(t), i_{w}(t) in the windings U, V, W may be used for control. Preferably, field-oriented control methods may be applied. A sensorless control method is described in WO 99/39430 A1, for example. Field-oriented control or any vector control can be accomplished thanks to the calculation of the motor flux angle or rotor position using fundamental-wave model-based approaches. Fundamental-wave model-based approaches are typically used in high and medium motor speeds. Around zero speeds, large stator voltage distortions may arise due to inverter switching properties. In railway applications, zero and near-zero electrical speed is a frequent point of operation (e.g. forward braking). To avoid open-loop control in this speed region, saliency extraction using transient models can be implemented. Spatial saliencies are spatial asymmetries of electric machines 7 that become visible in the transient current after a voltage step or voltage phasor is injected. This will be described below. However, as the focus of this disclosure is not on the control of the electric machine 7 but the detection of mechanical defects, the applicable control methods are not further described. It shall only be noted that any suitable sensorless control method may be applied by the control unit 30. A suitable control method is, for example, described in Q. Chen, Q. Li, P. Stolze, R. Kennel and D. Schröder, "Anisotropy-based Sensorless Control for Electrical Drives - Part I: Basic Principle," 2021 22nd IEEE International Conference on Industrial Technology (ICIT), Valencia, Spain, 2021, pp. 1335-1340.

In Fig. 5, only two sensors 31 for measuring currents are used. However, as the currents iᵤ(t), iᵥ(t), i_{w}(t) sum up to 0, it is sufficient to measure only two currents iᵤ(t), iᵥ(t) in the windings of the electric machine 7 and to calculate the third current i_{w}(t).

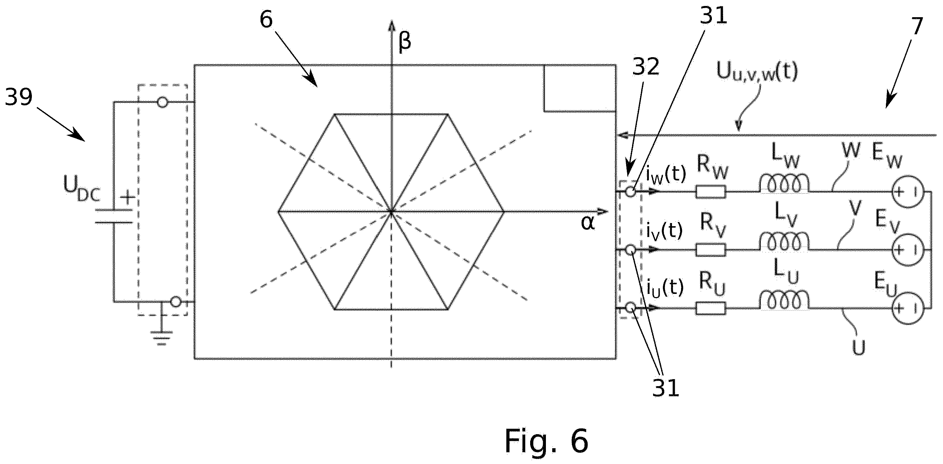

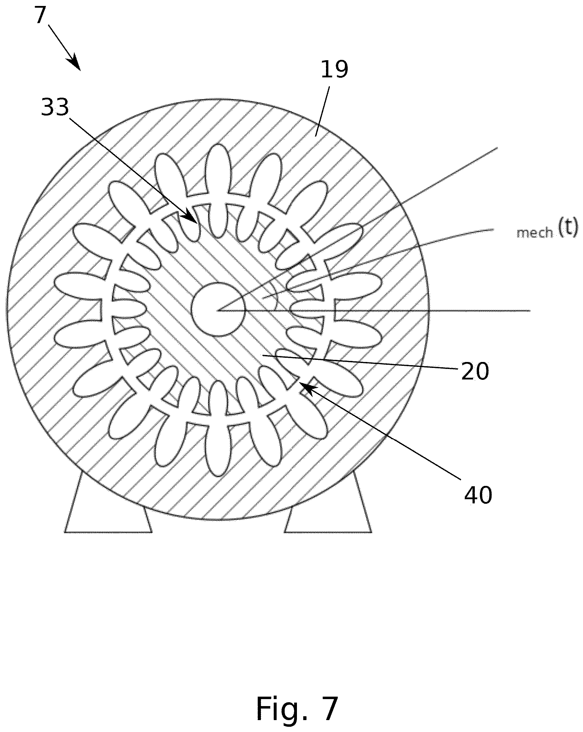

Fig. 6 shows a schematic view of the electric machine 7, which is preferably an induction machine. The electric machine 7 is driven by the converter 6, which has a plurality of electronic switches (not shown), for example semiconductor switches. The converter 6 is configured to output voltages with predefined frequencies, amplitudes and (zero) phase angles at an output 32 by means of appropriate switching operations. A voltage U_{DC} is applied to the converter 6 as power supply 39. The output 32 of the converter 6 is connected to the phase windings U, V, W of the electric machine 7. Due to the generated voltages of the converter 6, a rotating magnetic field is generated in an air gap 40 of the electric machine 7 between rotor 20 and stator 19 (see Fig. 7), which induces voltages in the rotor 20 of the electric machine 7 and can set the rotor 20 into rotation due to the resulting rotor currents.

The electric machine 7 is shown schematically in Fig. 6 as an electric circuit diagram. The electric machine 7 has three phase windings U, V, W with a phase winding resistance R_{U}, R_{V}, R_{W} and a phase winding inductance L_{U}, L_{V}, L_{W} respectively. The voltages E_{U}, E_{V}, E_{W} denote the voltages (back EMF) induced in the stator 19 of the electric machine 7. The currents iᵤ(t), iᵥ(t), i_{w}(t) flowing in the phase windings U, V, W can be measured or determined using sensors 31, respectively. The sensors 31 for measuring currents i_{U}(t), iᵥ(t), i_{w}(t) can be integrated into the converter 6 or can be independent elements.

Fig. 7 shows schematically an induction machine without windings in cross-section with a stator 19, a rotor 20 and a slotting 33, on each of the rotor 20 and stator 19. For illustration, an angular position θ_{mech}(t) of the rotor 20 is indicated.

The induction machine 2 shows asymmetries which can vary according to time and location, thus allowing information to be obtained on the angular position θ_{mech}(t) and/or the rotation speed of the rotor 20. An example of such an asymmetry is the slotting 33 of rotor 20 and/or stator 19. Another example of an asymmetry is the saturation of the magnetic flux paths in the electric machine 7. Both asymmetries cause temporal and spatial inductance changes in the operation of the electric machine 7, which can be determined by evaluating the currents iᵤ(t), iᵥ(t), i_{w}(t). For example, in a greatly simplified model to illustrate an asymmetry, it can be assumed, for example, that the three phase winding inductances L_{U}, L_{V}, L_{W} in the phase windings U, V, W each have a mean value L₀ and, as a function of a mechanical angular position θ_{mech}(t) of the rotor 20, deviate from this mean value L₀ sinusoidally (with an amplitude L_{M}) : ${L}_{U} \left({θ}_{mech}\left(t\right)\right) = {L}_{U , 0} + {L}_{U , M} sin \left({θ}_{mech}\left(t\right)\right)$ (2A) ${L}_{V} \left({θ}_{mech}\left(t\right)\right) = {L}_{V , 0} + {L}_{V , M} sin \left({θ}_{mech}\left(t\right)+\frac{2 π}{3}\right)$ (2B) ${L}_{W} \left({θ}_{mech}\left(t\right)\right) = {L}_{W , 0} + {L}_{W , M} sin \left({θ}_{mech}\left(t\right)+\frac{4 π}{3}\right)$ (2C)

The change in the angular position θ_{mech}(t) of the rotor 20 therefore also changes the inductances L_{U}, L_{V}, L_{W}. The variable inductance components can therefore also be referred to as modulated inductances. The changes in inductances L_{U}, L_{V}, L_{W} can be caused, for example, by the slotting 23 of the rotor 20 or stator 19 and/or the magnetic saturation of magnetic iron paths in the electric machine 7.

To determine inductance changes, electrical signals 40, preferably voltage signals U_{U}(t), U_{V}(t), U_{W}(t) (taken together as U_{U,V,W}(t) in Fig. 6), are applied to the phase windings U, V, W of the electric machine 7 and the resulting currents i_{U}(t), iᵥ(t), i_{w}(t) are measured using the sensors 31. The voltages or voltage pulses applied by the converter 6 to operate the electric machine 7 can be used as voltage signals U_{U}(t), U_{V}(t), U_{W}(t). The electrical signals can contain saliency excitation signals 34 to determine the operating state of the electric machine 7. The saliency excitation signals 34 can be essentially independent of the generation of a rotating field of the electric machine 7. For example, saliency excitation signals 34 can be used which are applied between or superimposed on the voltage (pulses) generated by the converter 6 for generating the rotating field. In general, voltage signals can be used as saliency excitation signals 34. It is also possible to use voltage waveforms with frequencies higher than that used by the converter 6 to generate the fundamental component of the rotating field.

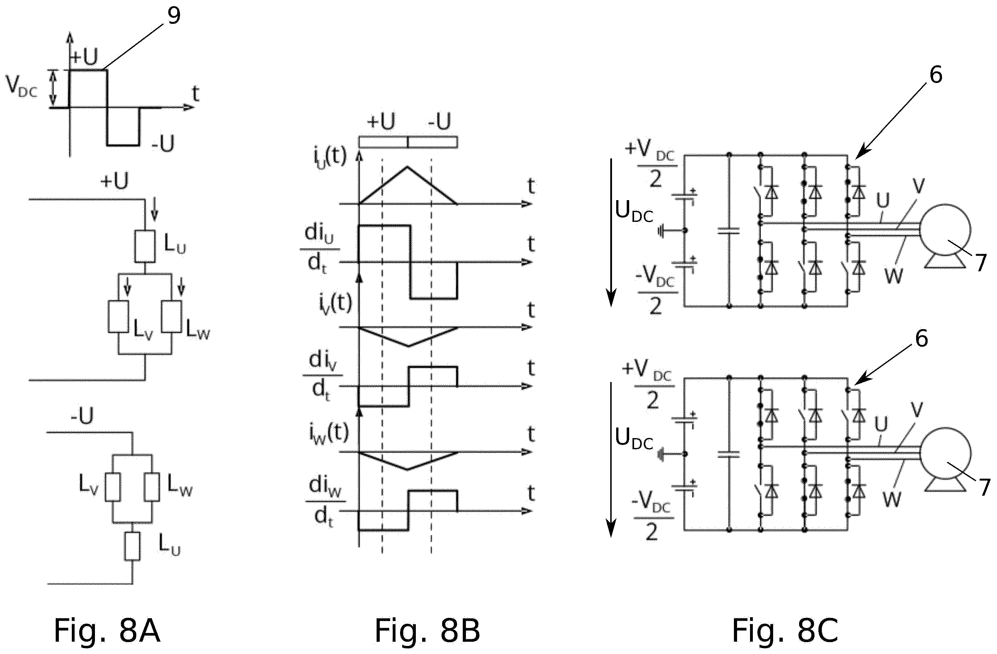

In Fig. 8A to Fig. 8C, the application of an example saliency excitation signal 34 and the resulting currents iᵤ(t), iᵥ(t), i_{w}(t) in the phase windings U, V, W are illustrated. Any ohmic resistances can be ignored here. Figures 8A-C show two switch positions of the converter 6, with which a rectangular saliency excitation signal 34 with a positive voltage +U and a negative voltage -U can be generated (having an amplitude of V_{DC}). If such a saliency excitation signal 34, which is shown against time t in the upper partial image of Fig. 8A, is applied, as shown in Fig. 8B, corresponding current slopes di_{U}/dt, di_{V}/dt, di_{W}/dt are obtained in the current waveforms iᵤ(t), iᵥ(t), i_{w}(t). In Fig. 8B, current waveforms iᵤ(t), iᵥ(t), i_{w}(t) and current slopes di_{U}/dt, di_{V}/dt, di_{W}/dt of each phase winding U, V, W are shown. Electrical equivalent circuit diagrams of the electric machine 7 with applied voltages +U and - U of the saliency excitation signal 34 are shown in the lower two images of Fig. 8A. If the saliency excitation signal 34 is applied, with a positive voltage +U, a positive current slope di_{U}/dt initially occurs in phase winding U (and thus a positive voltage drop across the phase winding inductance L_{U}) and a negative current slope di_{V}/dt or di_{W}/dt in each of the phase windings V and W (and thus a negative voltage drop across the phase winding inductances L_{V} and L_{W}). With a negative voltage - U of the saliency excitation signal 34, the case is reversed. Fig. 8B illustrates the current signals for the upper equivalent circuit diagram of Fig. 8A. Fig. 8C illustrates switching states of the converter 6 corresponding to the equivalent circuit diagrams of Fig. 8A.

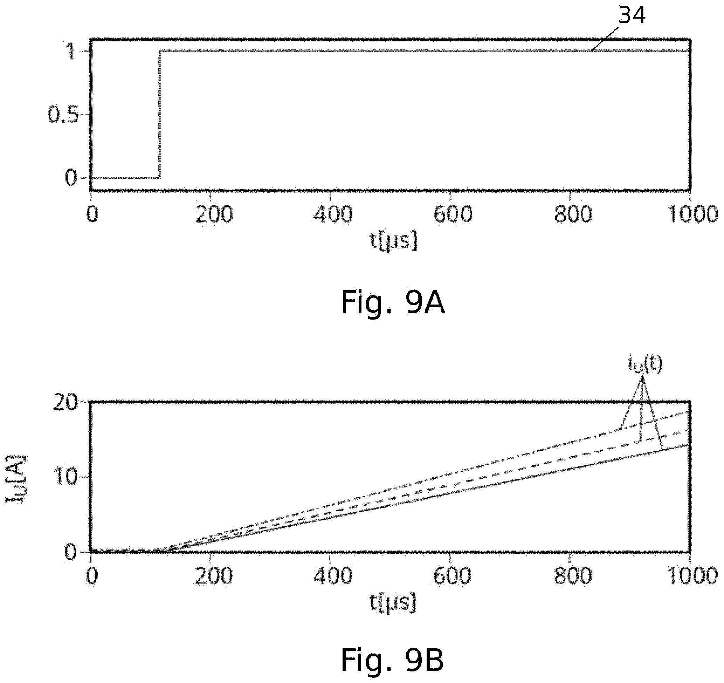

On account of different phase winding inductances L_{U}, L_{V}, L_{W} due to asymmetries in the electric machine 7, an additional deviation of the current slopes di_{U}/dt, di_{V}/dt, di_{W}/dt is obtained. This additional deviation is not shown in Fig. 8B, but can be seen in Fig. 9B, as explained in the following.

In one embodiment, rectangular saliency excitation signals 34, such shown in Fig. 9A, are applied to the phase windings U, V, W of the electric machine for the determination of inductance. Fig. 9A shows the saliency excitation signal 34 in normalized form. As a result of such an saliency excitation signal 34, which can be applied, for example, between the voltage pulses applied to generate the rotating field in the electric machine 7, a current slope of di_{U}/dt, di_{V}/dt, di_{W}/dt occurs in the phase windings U, V, W. Any ohmic resistance can be ignored here.

In Fig. 9B, as an example, three different current slopes di_{U}/dt of the phase current i_{U}(t) in phase winding U are shown at different times and thus for different phase winding inductances L_{U} due to the asymmetries of the electric machine 7. Similar illustrations also apply to the remaining phase windings V and W. The illustrations shown in the figures have been simplified and are intended to illustrate schematically the principle of the inductance determination. The variation in the current waveforms iᵤ(t), iᵥ(t), i_{w}(t) over time allows information to be obtained about the change in the inductances L_{U}, L_{V}, L_{W}.

The current slopes di_{U}/dt, di_{V}/dt, di_{W}/dt in the phase windings U, V and W, determined preferably at regular intervals, can then be combined using a mathematical equation into a combined signal ϑ_{Saliency}. Preferably, a mathematical equation for calculating a space vector is used to combine the current waveforms, for example ${ϑ}_{saliency} = \frac{{di}_{U} \left(t\right)}{dt} + \frac{{di}_{V} \left(t\right)}{dt} {e}^{j 2 \frac{π}{3}} + \frac{{di}_{W} \left(t\right)}{dt} {e}^{j 4 \frac{π}{3}} .$ (3)

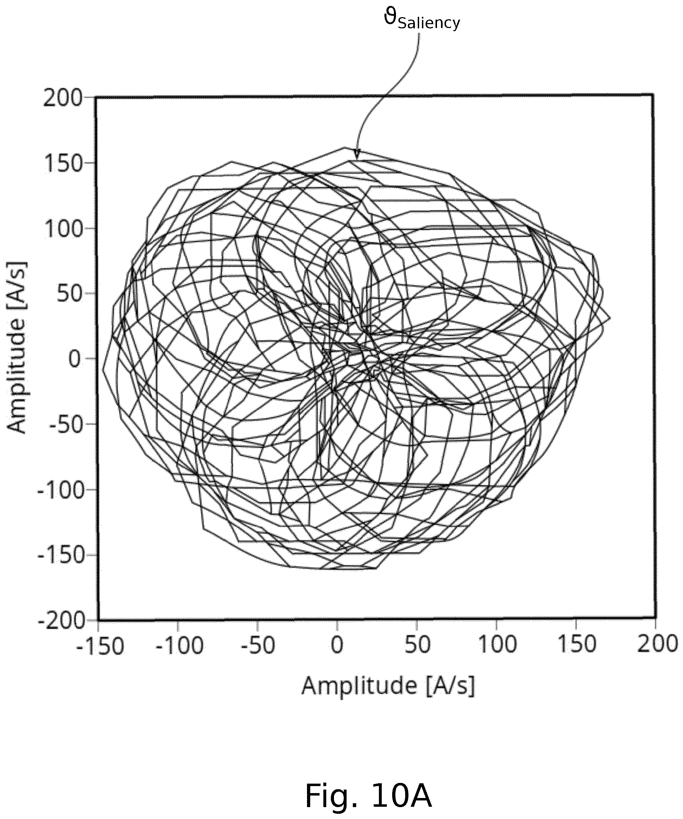

The combined signal ϑ_{Saliency} can also be referred to as "saliency signal". When the signal ϑ_{Saliency} is calculated as a space vector, ϑ_{Saliency} represents a tensor. The space vector of the signal ϑ_{Saliency} may also be denoted as ${\overline{v}}_{sal} = {\sum }_{n = 1}^{n = N} {\overline{v}}_{n} ,$ (4) where N is the number of saliencies, which will be described below. Figure 10A shows an exemplary trace of the tensor ϑ_{Saliency}, where both the abscissa and the ordinate represent an amplitude in amperes/second. The abscissa represents the real part and the ordinate the imaginary part of the signal ϑ_{Saliency}.

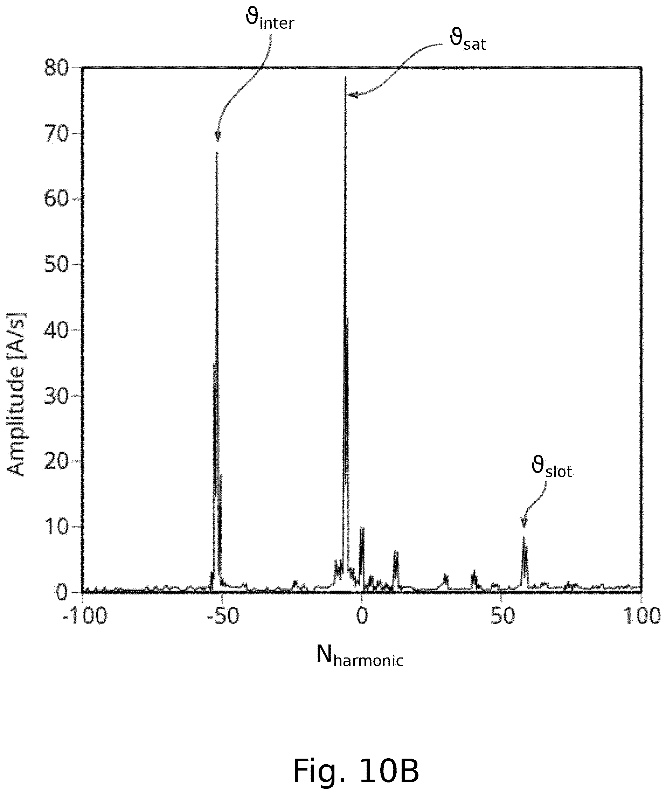

Fig. 10B illustrates the signal ϑ_{Saliency} shown in Fig. 10A in the frequency domain, where the abscissa plots the harmonics N_{harmonics} of the signal. As can be seen in Fig. 10B, ϑ_{Saliency} contains three distinct signal components, which may be referred to as saliencies. A first prominent signal component is formed by a slot signal component ϑₛₗₒₜ, which occurs due to the slotting 23 of the rotor 20 and of the stator 19 of the electric machine 7. A second prominent signal component is formed by a saturation signal component ϑₛₐₜ, which is attributable to the saturation of magnetic flux paths in the electric machine 7. A third significant signal component is formed by an intermodulation signal component ϑᵢₙₜₑᵣ, which is attributable to a physical interlinking of the slot signal component ϑₛₗₒₜ and the saturation signal component ϑₛₐₜ. The slot signal component ϑₛₗₒₜ, the saturation signal component ϑₛₐₜ and the intermodulation signal component ϑᵢₙₜₑᵣ each have different fundamental frequencies. In other words, in this simplified illustration, the number of saliencies is N=3.

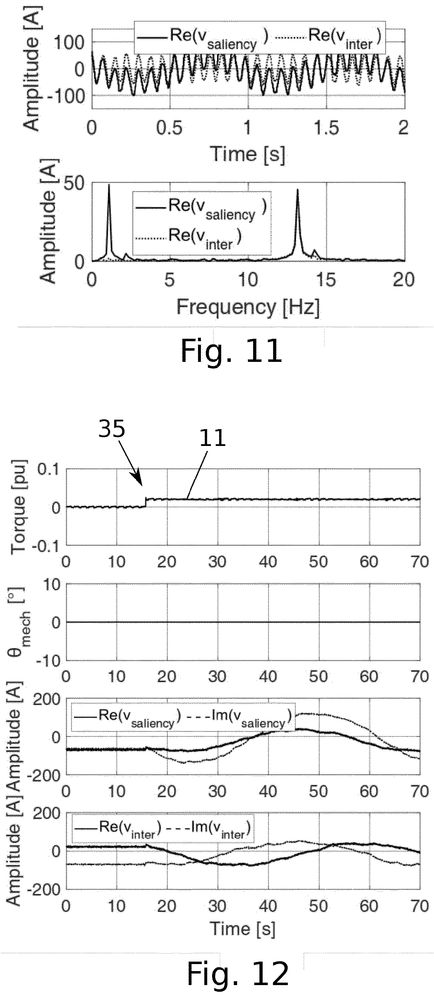

Fig. 11 illustrates at a rotor speed of 0 rpm and low load *v̅ₛₐₗ* and the decoupled intermodulation signal component ϑᵢₙₜₑᵣ. The upper image of Fig. 11 shows the real parts of the respective signals over time. The lower image shows the signals of the upper image in the frequency domain. It can be seen that the intermodulation signal component dominates the saliency signal ϑ_{Saliency} .

As described above, mechanical defects may occur in the drive unit 5 of a rail vehicle 1. These defects may occur in various locations in the drive unit 5, such as the suspension 8, the transmission 11 or the shaft 10. The inventors have found out that mechanical defects can introduce signal components with certain frequencies into the saliency signal ϑ_{Saliency}, in particular into the intermodulation signal component ϑᵢₙₜₑᵣ and the saturation signal component ϑₛₐₜ, which are absent when those mechanical defects are not present. Thus, according to the invention, the saliency signal ϑ_{Saliency}, in particular the intermodulation signal component ϑᵢₙₜₑᵣ and/or the saturation signal component ϑₛₐₜ, are used to determine mechanical defects in the drive unit 5. Thereby, it is also possible to use further processed signals of the saliency signal ϑ_{Saliency}, in particular the intermodulation signal component ϑᵢₙₜₑᵣ and/or the saturation signal component ϑₛₐₜ, such as a signal transformed into the frequency domain or a squared signal.

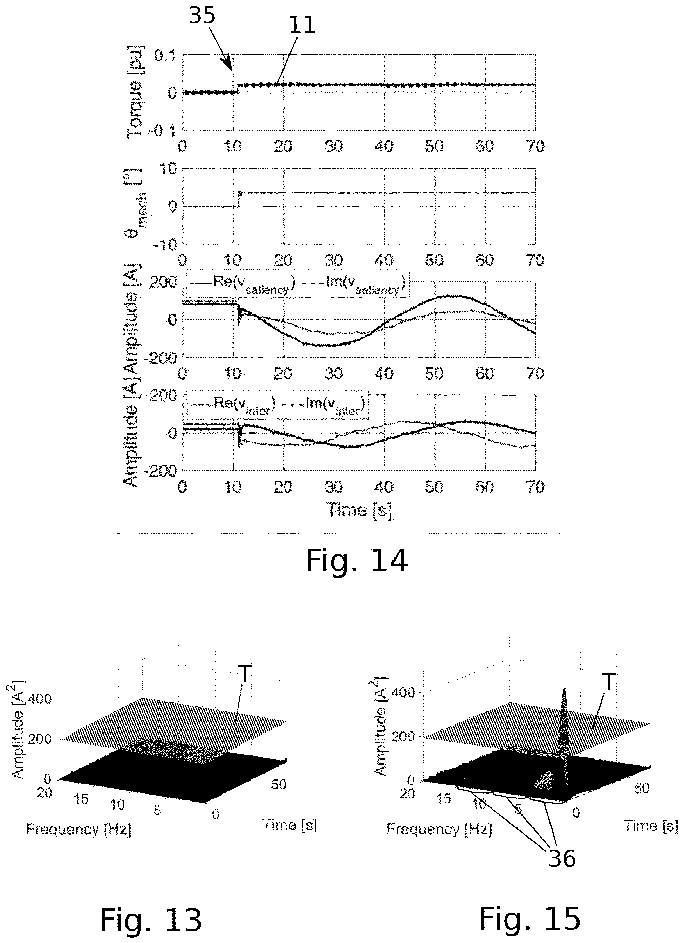

In order to determine mechanical defects, the electric machine 7 is excited by a drive unit excitation signal (not shown in the figures). The drive unit excitation signal is applied to the electric machine 7 and leads to the generation of torque M by the electric machine 7, as can be seen in Fig. 12, which illustrates the situation for a rail vehicle 1 with no mechanical defects in the drive unit 5. In Fig. 12, the rail vehicle 1 is in a stand still. The brakes 37 (see Fig. 1) are activated to avoid motion of the rail vehicle 1. In a particular preferred embodiment, the torque M is applied in the form of one or more torque steps 35. In general, the drive unit excitation signal, i.e., the torque steps 35, may be applied when the rail vehicle 1 is in motion or when the rail vehicle 1 stands still. Upon application of the drive unit excitation signal, an electrical signal waveform 41 (see Fig. 5), in particular a current signal waveform, in the phase windings U, V, W of the electric machine are measured with sensors 31 and the saliency signal ϑ_{Saliency} is determined. Then, preferably the intermodulation signal component ϑᵢₙₜₑᵣ is extracted from the saliency signal ϑ_{Saliency}, for instance by filtering. The analysation of the intermodulation signal component ϑᵢₙₜₑᵣ or a further processed signal thereof is advantageous as it is typically prominent in most operating states. However, also the slot signal component ϑₛₗₒₜ may be used instead of the intermodulation signal component ϑᵢₙₜₑᵣ, for example. It can be seen in Fig. 12 that the torque step 35 does not change the mechanical angular position θ_{mech}(t) of the rotor 20. The saliency signal ϑ_{Saliency} and the intermodulation signal component ϑᵢₙₜₑᵣ exhibit normal behaviour as expected. Also, the intermodulation signal component ϑᵢₙₜₑᵣ does not have any unexpected appearance in the frequency domain (Fig. 13).

Fig. 13 is a wavelet transform of the intermodulation signal component ϑᵢₙₜₑᵣ depicted in Fig. 12, wherein the fundamental frequency due to the torque step 35 has been filtered out. As can be seen in Fig. 13, also the wavelet transform does not show any abnormality with regard to the signal form. The intermodulation signal component ϑᵢₙₜₑᵣ only consists of the fundamental frequency, which has been filtered out.

Fig. 14 illustrates the time diagrams analogue to Fig. 12, but with a mechanical defect in the drive unit 5, specifically in the suspension 8. It can be already seen in the saliency signal ϑ_{Saliency} and in the intermodulation signal component ϑᵢₙₜₑᵣ that the form of the signal significantly differs from the form shown in Fig. 12. Upon application of the torque step 35, signal spikes both in the saliency signal ϑ_{Saliency} and the intermodulation signal component ϑᵢₙₜₑᵣ appear. It can be also seen in Fig. 14 that the mechanical angular position θ_{mech}(t) of the rotor 20 changes. This is a result of the broken suspension 8, which allows a small but limited rotation of the rotor 20.

Again, Fig. 15 is a wavelet transform of the intermodulation signal component ϑᵢₙₜₑᵣ depicted in Fig. 14, wherein the fundamental frequency due to the torque step 35 has been filtered out. However, in this case it can be clearly seen that the intermodulation signal component ϑᵢₙₜₑᵣ has a spike at ca. 3 Hz which appears around the application of the torque step 35. Thus, based on the intermodulation signal component ϑᵢₙₜₑᵣ, a mechanical defect in the drive unit can be considered as determined.

As mechanical defects introduce signal components into the saliency signal ϑ_{Saliency}, in particular into the intermodulation signal component ϑᵢₙₜₑᵣ, said signals can be used to determine whether the drive unit 5 is subject to a mechanical defect or not. To this end, preferably the intermodulation signal component ϑᵢₙₜₑᵣ or a further processed signal thereof is compared with a threshold value T, as can be seen in Fig. 15. The threshold value T may be constant, such that the threshold value T is depicted as plane in Fig. 15. However, the threshold value T may also be time and/or frequency dependent. The threshold value may be chosen such that it is significantly below the magnitude of the spike visible in Fig. 15. As an example, a value of 50 % of the spikes magnitude was found to lead to reliable detection. The threshold T may thus be determined empirically, with calculations and/or with simulations.

In a further aspect, the inventors have found out that mechanical defects in the drive unit 5 may introduce signals into the saliency signal ϑ_{Saliency} at different frequency ranges and with different magnitudes, depending on their specific location in the drive unit 5. For example, a mechanical defect in the suspension 8 may introduce a signal with a different frequency and/or magnitude in comparison to a mechanical defect in the transmission 11 or the shaft 10. In order to localise the mechanical defect in the drive unit 5, the saliency signal ϑ_{Saliency}, in particular the intermodulation signal component ϑᵢₙₜₑᵣ, may be analysed with regard to this respect. Preferably, frequency ranges 36 of the saliency signal ϑ_{Saliency} are accorded to parts or sections of the drive unit 5, such as the suspension 8 and the transmission 11. Further, individual threshold values T are accorded to the frequency ranges 36. The threshold values T may all be the same value (see Fig. 15) or be different from each other. A defect in a part or in a section of the drive unit 5 may be determined when a part of the transformed saliency signal ϑ_{Saliency} in a frequency range exceeds the accorded threshold value T. Through the association of a frequency range 36 to a section, such as the suspension 8, the transmission 11, the shaft 10 and the bogie 9, or section of the drive unit 5, the mechanical defect can be localized.

One advantage of the inventive method is that additional sensors, such as encoders 28, can be saved when controlling the electric machine 7 and detecting mechanical defects in the drive unit 5. Another advantage is that the inventive method is reliable and fast, also at the start-up of the electric machine and the control thereof. However, one problem during the start-up is that the angular position θ_{mech}(t) of the rotor 20 is unknown when sensorless methods, i.e. no rotary encoders 28, are used. In order to overcome this deficiency, the initial amplitudes and/or phase angles of the slot signal component ϑₛₗₒₜ and the intermodulation signal component ϑᵢₙₜₑᵣ may be estimated, preferably iteratively. To this end, in particular converging algorithms can be used. In the following, one exemplary algorithm will be described. However, the invention is not limited to the following algorithm. Also, other algorithms based on geometrical considerations may be used. They may have in common that the vector of the saturation signal component ϑₛₐₜ is known.

The above-described vector of the saliency signal ϑ_{Saliency} according to equation (4) may be denoted as ${\overline{v}}_{sal} = {\overline{v}}_{sat} + {\overline{v}}_{slot} + {\overline{v}}_{inter} = {A}_{sat} ⋅ {e}^{i ⋅ \left({γ}_{sat}\right)} + {A}_{slot} {⋅}^{i ⋅ \left({γ}_{slot}\right)} + {A}_{inter} ⋅ {e}^{i ⋅ \left({γ}_{inter}\right)}$ (5) wherein *v̅ₛₐₜ* is the vector of the saturation signal component ϑₛₐₜ, *v̅ₛₗₒₜ* is the vector of the slot signal component ϑₛₗₒₜ and *v̅ᵢₙₜₑᵣ* is the vector of the intermodulation signal component ϑᵢₙₜₑᵣ. i denotes the imaginary unit. Each vector has an amplitude A and a phase angle γ. To distinguish the amplitudes A and the phase angles γ of the respective signal components, the indices "sat", "slot" and "inter" have been added. For the phase angles γ, the following equations apply: ${γ}_{sat} = 2 ⋅ {θ}_{E} + {θ}_{sat}$ (6) ${γ}_{slot} = - {N}_{R} ⋅ {θ}_{R} + {θ}_{slot}$ (7) ${γ}_{inter} = {N}_{R} ⋅ {θ}_{R} - 2 ⋅ {θ}_{E} + {θ}_{inter} .$ (8)

Here, θ_{E} is the stator current angle and θ_{R} is the rotor position, which corresponds to θ_{mech}(t). N_{R} is the number of rotor slots. θₛₐₜ, θₛₗₒₜ and θᵢₙₜₑᵣ represent phase shifts between the phase angles γ, which can be also considered as zero-phase angles.

In no-load conditions, the following relation between the phase shifts typically applies: ${θ}_{inter} = - {θ}_{slot} - {θ}_{sat} .$ (9)

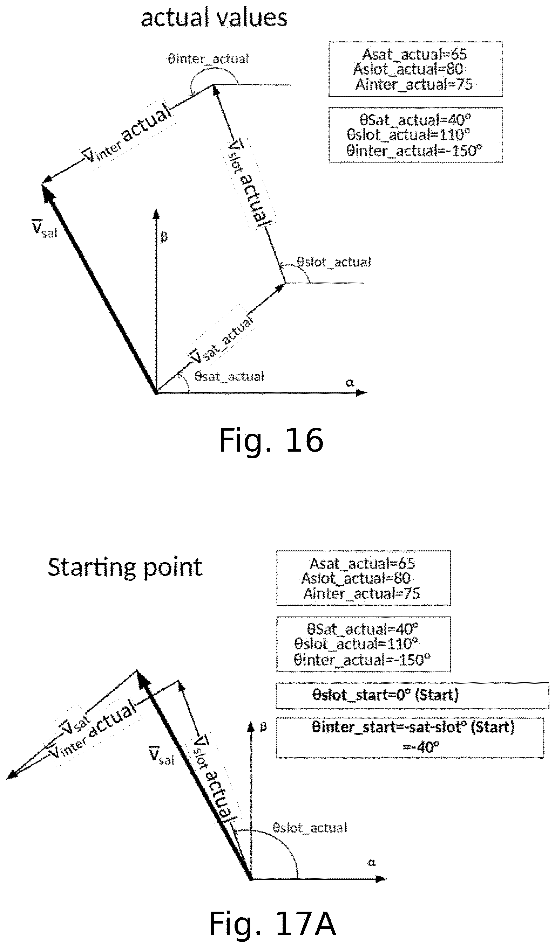

The relation depends on the design of the electric machine 7. In this illustrative example, equation (9) is used. For illustrative purposes it shall be assumed in the following that Aₛₐₜ=65, Aₛₗₒₜ=80, Aᵢₙₜₑᵣ=75, θₛₐₜ=40°, θₛₗₒₜ=110°, θᵢₙₜₑᵣ=-150° applies. The rotor is locked and the machine operated at no-load condition. The units of the amplitudes have been omitted here. According to equation (5), the saliency vector *v̅ₛₐₗ* has a phase angle of γₛₐₗ=118° with an amplitude of Aₛₐₗ=90. The result is illustrated in Fig. 16 with a real axis denoted with α and an imaginary axis denoted with β.

In the figures it distinguished between actual values and estimated values for the sake of understanding. To this end, actual values are marked with "actual", while estimated values are marked with "start" or "iter", depending on the steps of the algorithm.

Since the rotor position θ_{R} is unknown, it is not possible to determine the phase angles γₛₗₒₜ and γᵢₙₜₑᵣ. However, given that stator current angle θ_{E} is known, and torque M is known, the saturation saliency vector *v̅ₛₐₜ* is fully known. Therefore, it is possible to feedforward compensate this vector, which is shown in Fig. 17A.

In a first step, also referred to as starting point of the algorithm in Fig. 17A and denoted with the index-addon "start", it is proposed to select an arbitrary value for the phase shift θₛₗₒₜ, preferably θ_{slot_start}=0. As θₛₐₜ=40° is known, θ_{inter_start} calculates to θ_{inter_start}=-40° due to equation (9).

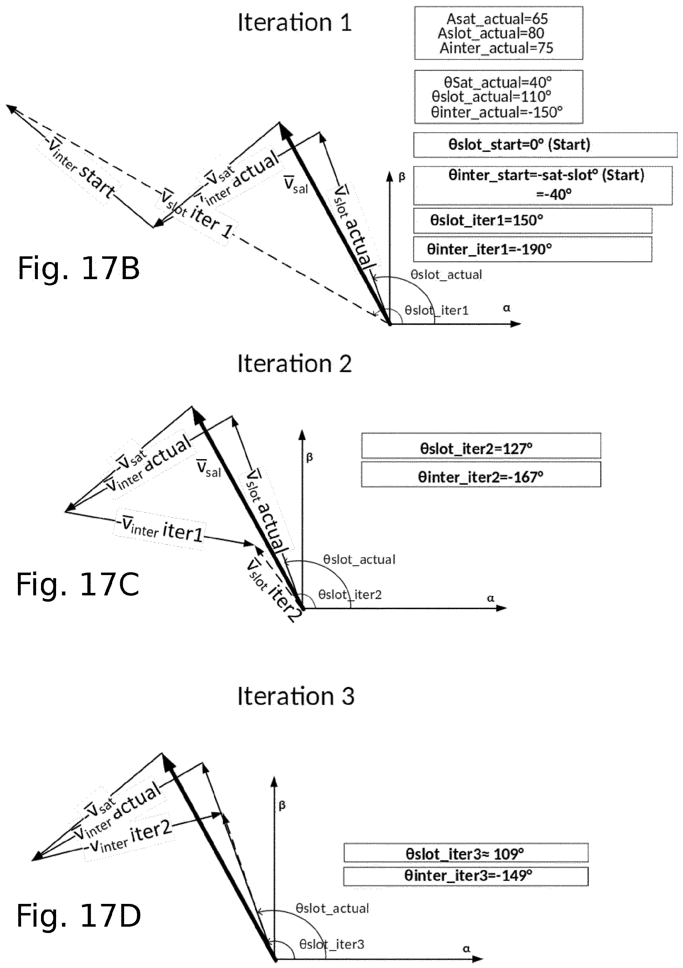

With θ_{inter_start}=-40°, saturation is compensated and the vector *v̅ᵢₙₜₑᵣ* of the intermodulation signal component ϑᵢₙₜₑᵣ is compensated in iteration 1 (see index iter_1), resulting in a new estimated θₛₗₒₜ. This is illustrated in Fig. 17B.

As observed, the compensation of the intermodulation vector *v̅ᵢₙₜₑᵣ* using the intermodulation starting angle θ_{inter_start} is not accurate. However, this iteration results in a new estimated slotting angle θₛₗₒₜ from the first iteration, namely θ_{slot_iter_1}=150°. Using equation (9) again, the 1^{st}-iteration intermodulation angle can be now calculated to θ_{inter_iter1}=-190° and used in a new iteration.

With θ_{inter_iter1}=-190°, saturation is compensated and the vector *v̅ᵢₙₜₑᵣ* of the intermodulation signal component ϑᵢₙₜₑᵣ is compensated in iteration 2 (see the index iter_2). This is shown in Fig. 17C. This leads to a new estimated slotting angle θₛₗₒₜ from the second iteration, namely θ_{slot_iter_2}=127°. Using equation (9) again, the 2^{st}-iteration intermodulation angle can be now calculated to θ_{inter_iter1}=-167° and used in a new iteration.

After one more similar iteration, it can be observed that the estimated slotting angle θₛₗₒₜ already comes close the actual slotting angle, which is shown in Fig. 17D. Thus, within a few PWM periods, it is possible to obtain the initial rotor slot position with a suitable accuracy.

Thus, with iterative methods as the one shown above, it is possible to estimate the initial amplitude and/or phase angles of intermodulation signal component ϑᵢₙₜₑᵣ and/or a slot signal component ϑₛₗₒₜ at the start-up of the electrical machine. Therefore, it is possible to determine mechanical defects in the drive unit already shortly after the start-up of an electrical machine 7.

## Claims

1. Method for detecting a mechanical defect of a drive unit (5), in particular a drive unit (5) of a rail vehicle (1), wherein the drive unit (5) comprises a suspension (8), a converter (6) and an electric machine (7), the electric machine (7) having a stator (19), a rotor (20) and at least two phase windings (U,V,W), wherein the method comprises the following steps:
providing electrical signals (40) to one or more of the at least two phase (U,V,W) windings by the converter (6);
measuring an electrical signal waveform, in particular a current signal waveform, in one or more of the at least two phase windings (U,V,W);
determining a saliency signal (ϑ_{Saliency}) which preferably comprises an intermodulation signal component (ϑᵢₙₜₑᵣ), a slot signal component (ϑₛₗₒₜ) and/or a saturation signal component (ϑₛₐₜ) from the measured electrical signal waveform; **characterized by**
comparing the saliency signal (ϑ_{Saliency}), in particular the intermodulation signal component (ϑᵢₙₜₑᵣ), the slot signal component (ϑₛₗₒₜ) and/or the saturation signal component (ϑₛₐₜ), or a further processed signal thereof with at least one threshold value (T);
determining that a mechanical defect of the drive unit (5) has occurred when the saliency signal (ϑ_{saliency}), in particular the intermodulation signal component (ϑᵢₙₜₑᵣ), the slot signal component (ϑₛₗₒₜ) and/or the saturation signal component (ϑₛₐₜ), or the further processed signal exceeds the at least one threshold value (T).

2. Method according to claim 1, **characterized in** the saliency signal (ϑ_{Saliency}), in particular the intermodulation signal component (ϑᵢₙₜₑᵣ), or the further processed signal is transformed into a frequency domain or a time-frequency domain, wherein within at least one frequency range (36) at least one part of the transformed saliency signal (ϑ_{Saliency}) and/or of the transformed further processed signal is compared with the at least one threshold value (T).

3. Method according to claim 2, **characterized in that** the transformation into the frequency domain is carried out by a frequency transform, in particular Fourier Transform, and the transformation into the time-frequency domain is carried out by a time-frequency-transform, in particular a Wavelet Transform or a Short-Time Fourier Transform.

4. Method according to claim 2 or 3, **characterized in that** frequency ranges (36) of the saliency signal (ϑ_{Saliency}), in particular the intermodulation signal component (ϑᵢₙₜₑᵣ), or of the further processed signal are accorded to sections of the drive unit and that threshold values (T) are accorded to the frequency ranges (36), wherein the mechanical defect of a section of the drive unit (5) is determined when a part of the transformed saliency signal (ϑ_{Saliency}) exceeds the accorded threshold value (T) of the respective frequency range (36) or a part of the further processed signal exceeds the accorded threshold value of the respective frequency range (36).

5. Method according to claim 4, **characterized in that** the drive unit (5) at least comprises the suspension (8), the electric machine (7) and a transmission (11) and preferably a bogie (9).

6. Method according to any one of claims 1 to 5, **characterized in that** the at least one threshold value (T) is related to an amplitude value.

7. Method according to any one of claims 1 to 6, **characterized in that** the electric machine (7) is an induction machine, a reluctance machine, or a synchronous machine.

8. Method according to any one of claims 1 to 7, **characterized in that** the drive unit (5) is disposed in a rail vehicle (1), in particular a train, a locomotive or a tram, and the method is carried out when the rail vehicle (1) initially stands still.

9. Method according to claim 8, **characterized in that** at least one brake (37) of the rail vehicle (1) is activated to counteract acceleration of the rail vehicle (1).

10. Method according to any one of claims 1 to 9, **characterized in that** a drive unit excitation signal is generated and applied to the electric machine (7) and, upon generation of the drive unit excitation signal, the saliency signal (ϑ_{Salien-cy}), in particular the intermodulation signal component (ϑᵢₙₜₑᵣ), or the further processed signal is determined.

11. Method according to claim 10, **characterized in that** the drive unit excitation signal leads to the generation of torque (M) by the electric machine (7), which torque (M) is preferably applied in the form of one or more torque steps (35).

12. Method according to any one of claims 1 to 11, **characterized in that** the electric machine (7) is suspended by the suspension (8), preferably wherein a retention element (21) is provided.

13. Method according to any one of claims 1 to 12, **characterized in that** initial values for amplitudes (Aₛₗₒₜ, Aᵢₙₜₑᵣ) and/or phase angles, in particular for zero-phase angles (θₛₗₒₜ, θᵢₙₜₑᵣ), of the intermodulation signal component (ϑᵢₙₜₑᵣ) and/or of a slot signal component (ϑₛₗₒₜ) are estimated, preferably iteratively.

14. Control unit (30) for detecting a mechanical defect of a drive unit (5), in particular a drive unit of a rail vehicle (1), the control unit (30) being configured to measure an electrical signal waveform (41), in particular current signal waveform, in one or more phase windings (U,V,W) of an electric machine (7), wherein the control unit (30) comprises a processing unit (38) which is configured to determine a saliency signal (ϑ_{Saliency}) which preferably comprises an intermodulation signal component (ϑᵢₙₜₑᵣ), a slot signal component (ϑₛₗₒₜ) and/or a saturation signal component (ϑₛₐₜ) from the measured electrical signal waveform,
**characterized in that** the processing unit (30) is further configured to compare the saliency signal (ϑ_{Saliency}), in particular the intermodulation signal component (ϑᵢₙₜₑᵣ), the slot signal component (ϑₛₗₒₜ) and/or the saturation signal component (ϑₛₐₜ), or a further processed signal thereof with at least one threshold value (T), and to
determine that a mechanical defect of the drive unit (5) has occurred when the saliency signal (ϑ_{saliency}), in particular the intermodulation signal component (ϑᵢₙₜₑᵣ), the slot signal component (ϑₛₗₒₜ) and/or the saturation signal component (ϑₛₐₜ), or the further processed signal exceeds the at least one threshold value (T).

15. Vehicle, in particular rail vehicle, comprising a drive unit having:
a converter (6);
an electric machine (7);
a suspension (8); and
a control unit (30) according to claim 14.

## Amended claims

### Amended claims in accordance with Rule 137(2) EPC.

1. Method for detecting a mechanical defect of a suspension (8) of a drive unit (5), in particular a drive unit (5) of a rail vehicle (1), wherein the drive unit (5) comprises the suspension (8), a converter (6) and an electric machine (7), the electric machine (7) having a stator (19), a rotor (20) and at least two phase windings (U,V,W), wherein the method comprises the following steps:
providing electrical signals (40) to one or more of the at least two phase (U,V,W) windings by the converter (6);
measuring an electrical signal waveform, in particular a current signal waveform, in one or more of the at least two phase windings (U,V,W);
determining a saliency signal (ϑ_{Saliency}) which comprises an intermodulation signal component (ϑᵢₙₜₑᵣ), a slot signal component (ϑₛₗₒₜ) and/or a saturation signal component (ϑₛₐₜ) from the measured electrical signal waveform;
**characterized by**
comparing the intermodulation signal component (ϑᵢₙₜₑᵣ) and/or the saturation signal component (ϑₛₐₜ), or a further processed signal thereof with at least one threshold value (T);
determining that a mechanical defect in the suspension (8) of the drive unit (5) has occurred when the intermodulation signal component (ϑᵢₙₜₑᵣ) and/or the saturation signal component (ϑₛₐₜ), or the further processed signal exceeds the at least one threshold value (T).

2. Method according to claim 1, **characterized in that** the intermodulation signal component (ϑᵢₙₜₑᵣ) and/or the saturation signal component (ϑₛₐₜ), or the further processed signal is transformed into a frequency domain or a time-frequency domain, wherein within at least one frequency range (36) at least one part of the transformed saliency signal (ϑ_{Saliency}) and/or of the transformed further processed signal is compared with the at least one threshold value (T).

3. Method according to claim 2, **characterized in that** the transformation into the frequency domain is carried out by a frequency transform, in particular Fourier Transform, and the transformation into the time-frequency domain is carried out by a time-frequency-transform, in particular a Wavelet Transform or a Short-Time Fourier Transform.

4. Method according to claim 2 or 3, **characterized in that** frequency ranges (36) of the intermodulation signal component (ϑᵢₙₜₑᵣ) and/or the saturation signal component (ϑₛₐₜ), or of the further processed signal are accorded to sections of the drive unit and that threshold values (T) are accorded to the frequency ranges (36), wherein the mechanical defect of a section of the drive unit (5) is determined when a part of the transformed intermodulation signal component (ϑᵢₙₜₑᵣ) and/or of the transformed saturation signal component (ϑₛₐₜ), or of the transformed further processed signal exceeds the accorded threshold value (T) of the respective frequency range (36) or a part of the further processed signal exceeds the accorded threshold value of the respective frequency range (36).

5. Method according to claim 4, **characterized in that** the drive unit (5) at least comprises the suspension (8), the electric machine (7) and a transmission (11) and preferably a bogie (9).

6. Method according to any one of claims 1 to 5, **characterized in that** the at least one threshold value (T) is related to an amplitude value.

7. Method according to any one of claims 1 to 6, **characterized in that** the electric machine (7) is an induction machine, a reluctance machine, or a synchronous machine.

8. Method according to any one of claims 1 to 7, **characterized in that** the drive unit (5) is disposed in a rail vehicle (1), in particular a train, a locomotive or a tram, and the method is carried out when the rail vehicle (1) initially stands still.

9. Method according to claim 8, **characterized in that** at least one brake (37) of the rail vehicle (1) is activated to counteract acceleration of the rail vehicle (1).

10. Method according to any one of claims 1 to 9, **characterized in that** a drive unit excitation signal is generated and applied to the electric machine (7) and, upon generation of the drive unit excitation signal, the saliency signal (ϑ_{Saliency}), in particular the intermodulation signal component (ϑᵢₙₜₑᵣ), or the further processed signal is determined.

11. Method according to claim 10, **characterized in that** the drive unit excitation signal leads to the generation of torque (M) by the electric machine (7), which torque (M) is preferably applied in the form of one or more torque steps (35).

12. Method according to any one of claims 1 to 11, **characterized in that** the electric machine (7) is suspended by the suspension (8), preferably wherein a retention element (21) is provided.

13. Method according to any one of claims 1 to 12, **characterized in that** initial values for amplitudes (Aₛₗₒₜ, Aᵢₙₜₑᵣ) and/or phase angles, in particular for zero-phase angles (θₛₗₒₜ, θᵢₙₜₑᵣ), of the intermodulation signal component (ϑᵢₙₜₑᵣ) and/or of a slot signal component (ϑₛₗₒₜ) are estimated, preferably iteratively.

14. Control unit (30) for detecting a mechanical defect of a suspension (8) of a drive unit (5), in particular a drive unit of a rail vehicle (1), the control unit (30) being configured to measure an electrical signal waveform (41), in particular current signal waveform, in one or more phase windings (U,V,W) of an electric machine (7), wherein the control unit (30) comprises a processing unit (38) which is configured to determine a saliency signal (ϑ_{Saliency}) which comprises an intermodulation signal component (ϑᵢₙₜₑᵣ), a slot signal component (ϑₛₗₒₜ) and/or a saturation signal component (ϑₕₐₜ) from the measured electrical signal waveform,
**characterized in that** the processing unit (30) is further configured to compare the intermodulation signal component (ϑᵢₙₜₑᵣ) and/or the saturation signal component (ϑₛₐₜ), or a further processed signal thereof with at least one threshold value (T), and to
determine that a mechanical defect in the suspension (8) of the drive unit (5) has occurred when the saliency signal (ϑ_{sali-ency}) the intermodulation signal component (ϑᵢₙₜₑᵣ) and/or the saturation signal component (ϑₛₐₜ), or the further processed signal exceeds the at least one threshold value (T).

15. Vehicle, in particular rail vehicle, comprising a drive unit having:
a converter (6);
an electric machine (7);
a suspension (8); and
a control unit (30) according to claim 14.
